# FASCICULE DE BREVET EUROPEEN

(11) **EP 0 994 778 B1**
(45) Date de publication et mention de la délivrance du brevet: **06.02.2002**
(21) Numéro de dépôt: 98938730.3
(22) Date de dépôt: 10.07.1998
(51) Int. Cl.: B41F 15/44, H05K 3/12, B05C 11/04, B05B 11/04

(54) **RACLE D'APPLICATION DE PRODUITS PRESENTANT UN DEGRE DE VISCOSITE IMPORTANT ET DES CARACTERISTIQUES DE THIXOTROPIE SUR UN SUBSTRAT POUVANT PRESENTER DES VARIATIONS DE HAUTEUR, A TRAVERS UN POCHOIR, APPLIQUE AU DIT SUBSTRAT**
RAKEL ZUM AUFTRAGEN VON SEHR VISKOSEN UND THIXOTROPISCHEN MEDIEN DURCH EINE SCHABLONE AUF EIN SUBSTRAT VON VARIABLER HÖHE
DOCTOR BLADE FOR APPLYING PRODUCTS WITH HIGH DEGREE OF VISCOSITY AND THIXOTROPIC PROPERTIES ON A SUBSTRATE VARYING IN HEIGHT, THROUGH A STENCIL, APPLIED TO SAID SUBSTRATE

(30) Priorité: 11.07.1997 FR 9708898
(43) Date de publication de la demande: 26.04.2000
(73) Titulaire: Societe Novatec S.A., 82000 Montauban (FR)
(72) Inventeur: BOURRIERES, Francis, F-82000 Montauban (FR); KAISER, Clément, F-82000 Montauban (FR)
(74) Mandataire: Ravina, Bernard
(86) Numéro de dépôt international: FR9801515
(87) Numéro de publication internationale: WO9902346

(56) Documents cités:
- CH-A- 652 343
- DE-A- 3 614 304
- US-A- 4 121 519
- US-A- 4 604 966
- PATENT ABSTRACTS OF JAPAN vol. 097, no. 007, 31 juillet 1997 & JP 09 057942 A (SONY CORP), 4 mars 1997

## Description

La présente invention concerne une racle d'application de produits présentant un degré de viscosité important et des caractéristiques de thixotropie sur un substrat pouvant présenter des variations de hauteur, à travers un pochoir qui peut également présenter des variations de hauteur, appliqué au dit substrat, les ouvertures du dit pochoir pouvant être de très petite dimension.

Les crèmes à braser, les colles conductrices ou les colles epoxy qui doivent être appliquées en couche épaisse, par exemple comprise entre 0,1 et 1 millimètre, par des procédés de sérigraphie, notamment dans le domaine de la fabrication des cartes de circuits électroniques, présentent nécessairement une viscosité importante et des caractéristiques de thixotropie.

La viscosité importante est nécessaire pour que le dépôt sérigraphié reste stable et ne s'affaisse pas ou ne se déforme pas dans le temps.
La thixotropie est la capacité du produit de voir abaisser son degré de viscosité par fluidification lorsqu'il est soumis à des forces de cisaillage et de retrouver sa viscosité initiale lorsque le cisaillage cesse.
Cette fluidification est nécessaire afin que le produit hautement visqueux puisse passer dans les ouvertures du pochoir.

Les crèmes à braser seront l'exemple type de produit repris dans l'ensemble de la description.
Les crèmes à braser sont des produits très hétérogènes composés d'un alliage de particules métalliques (étain, plomb ou étain, plomb et argent) constituées de sphères dont le diamètre peut varier de 10 microns à 80 microns et d'une partie organique dénommée liant ou flux.

Différents types de lames de racles ont été proposés, généralement soit réalisées au moyen d'un profilé en polyuréthane de dureté 60 à 90 shores, soit réalisées à partir d'un clinquant en acier inoxydable d'épaisseur de l'ordre de 0,2 millimètre.

Les racles en polyuréthanne sont généralement utilisées pour la sérigraphie à l'aide d'écrans à mailles, en polyester ou en métal inoxydable, ou encore lorsque les pochoirs ont des pas d'interconnexion entre les ouvertures qui restent supérieurs à 0,635 millimètre.

Les racles en polyuréthanne ont l'avantage de ne pas être agressives par rapport au pochoir ou à l'écran, notamment lorsqu'il est en matière synthétique et également de permettre un raclage efficace et sans résidu sur le pochoir avec une force d'appui sur la racle relativement faible.

Par contre, ces racles présentent un certain nombre d'inconvénients :
- elles se déforment sur les ouvertures du pochoir et elles réentraînent une partie du produit contenu dans les ouvertures. Il en résulte des dépôts creusés.
- La racle se déforme au niveau de l'arête de travail en contact avec la surface du pochoir ; cela génère une modification importante de l'angle d'inclinaison de la racle par rapport à la surface du pochoir avec un écrasement du produit à transférer avec ségrégation de la partie métallique et de la partie organique dans le cas des crèmes à braser.
- On a constaté par ailleurs une usure rapide des racles polyuréthannes en raison de la déformation de l'arête de travail sur les ouvertures du pochoir et de la différence de dureté des composants de la crème à braser.
Cette usure rend la racle impropre à sa fonction.

Les racles métalliques évitent les inconvénients majeurs des racles polyuréthannes puisque l'arête en contact avec le pochoir s'use moins vite et qu'elles ne se déforment pas dans les ouvertures en réentraînant le produit. Elles présentent cependant un certain nombre d'inconvénients.

La dureté des racles, dont la résistance à la rupture est comprise entre 600 et 1600 newton au millimètre carré, use prématurément les pochoirs. Ce risque d'usure interdit d'ailleurs généralement l'utilisation de telles racles avec des écrans à mailles ou pour des pochoirs qui ne sont pas en métal dur, c'est à dire ayant un module d'élasticité supérieur ou égal à 140.000 newton par millimètre carré.

La racle métallique n'accepte pas de faibles rayons de pliage dans le domaine élastique.
De ce fait, la pression d'appui de la racle métallique sur le pochoir peut ne pas être homogène.
On constate en particulier que les racles métalliques, lorsqu'elles sont plus larges que le substrat, exercent une pression très importante au niveau des bords du substrat alors que les zones situées légèrement en retrait des bords sur environ 15 millimètres, subissent une pression nulle ou très faible d'où résulte un mauvais raclage et une mauvaise mise en contact entre le pochoir et le substrat dans ces zones.

Il est possible d'observer des phénomènes d'ondulation de la racle dans le sens longitudinal.
Cette absence d'homogénéité de pression cause une usure et une déformation, qui peut être permanente, du pochoir là où la pression est maximum et là où la pression est minimum on obtient un raclage partiel du produit qui entraîne un mauvais contrôle du produit déposé.

Il a été également constaté que les racles métalliques provoquent une déformation du substrat liée aux variations de pression qui peuvent être excessivement importantes.
Ces déformations sont particulièrement critiques lorsque le substrat est une carte de circuit imprimé sur le dos duquel doit être effectuée la sérigraphie et dont la face avant est déjà équipée de composants.

Dans ce cas, le soutien de la carte devient extrêmement délicat et il est indispensable de réduire au maximum, ce qui n'est pas possible avec les racles métalliques, la force d'appui de la racle et surtout d'éviter des variations de pression excessives qui peuvent détériorer le substrat ou les composants montés sur la face avant.
En outre, une déflexion importante de la racle métallique lorsque l'on veut sérigraphier à des vitesses importantes (supérieures à 50 millimètres/seconde), conduit à augmenter considérablement la force d'appui de la racle sur le pochoir.

La technique antérieure a essayé de remédier à ces inconvénients des racles en polyuréthanne ou racles élastiques souples et des racles métalliques en essayant de combiner les deux.

Le brevet européen EP 0.011.314 décrit une racle constituée d'une lame élastique en acier dont le bord inférieur comporte une bande de bordure de très faible hauteur tournée vers l'écran et qui est en matière synthétique.

Le brevet européen EP 0.167.906 décrit une racle du même type que celle du brevet précédent conçue pour les écrans en matière textile et pour le transfert d'encre.
Cette racle comprend une barre support en un matériau élastique dur, en fait en métal, qui doit être le plus rigide possible et peut d'ailleurs à cet effet être doté d'une nervure longitudinale ou être en deux épaisseurs et dont l'extrémité porte une lame profilée en un matériau souple qui est le seul organe qui contribue à la distribution de l'encre à travers le pochoir.

Le brevet US 4 604 966 (Harold Kohn) décrit une racle rigide fonctionnant dans un tambour percé et recouvert d'un pochoir afin de déposer de la crème à braser sur un substrat.
La racle selon ce brevet présente une partie métallique rigide avec une lame en silicone.
Il n'y a pas réelle coopération entre la lame en silicone et la racle rigide qui ne sert que de support.

Le document Patent abstract of JAPAN JP 09057942 décrit une racle comprenant une première partie rigide et une deuxième partie souple qui dépasse la première et qui présente un chanfrein à son bord inférieur.
Seule la partie souple travaille élastiquement.

Le brevet US 4 121 519 décrit une racle utilisée en sérigraphie traditionnelle utilisant de l'encre à faible degré de viscosité et n'ayant aucune caractéristique de thixotropie.
La racle selon ce brevet est maintenue entre deux éléments rigidifiants sans qu'il soit expliqué qu'il y ait une relation entre eux intervenant sur la qualité des dépôts.

Le brevet DE 3614304 (KÜRTEN, KAISER) utilise une racle souple de part et d'autre de laquelle sont disposées des lames de renfort pour permettre de faire varier la longueur de la racle souple.
Ce brevet ne donne aucune information sur la rigidité ou la souplesse de l'ensemble.

Le brevet CH 652 343 (Meier) décrit une racle avec bande de raclage en caoutchouc disposée entre deux éléments rigides.

Les racles selon ces brevets sont inapplicables à l'application de produits à haut degré de viscosité et à caractéristiques de thixotropie comme visé par l'invention, produits pour lesquels l'ensemble de la racle est actif dans la réalisation de la sérigraphie comme cela sera expliqué dans la description, la racle selon l'invention étant à la fois conçue pour présenter à la fois raideur et élasticité et un moment d'inertie, ce qui permet d'absorber les ondulations de grande longueur et de petite longueur. Et de plus, les racles selon ces brevets ne résolvent pas les inconvénients des racles polyuréthannes qui ont été exposées précédemment.

L'invention vise à apporter des solutions aux problèmes des racles de l'art antérieur.
A cet effet, la racle d'application d'un produit présentant un degré de viscosité important et des caractéristiques de thixotropie sur un substrat qui peut présenter des variations de hauteur, à travers un pochoir appliqué au dit substrat, se caractérise en ce que elle est constituée par superposition l'une contre l'autre d'au moins deux lames flexibles de raideur différente et de hauteur différente dont une, la moins raide, dépasse le bord inférieur de la plus raide, ladite lame la moins raide étant au contact du produit à appliquer et la lame la plus raide étant du côté opposé, ladite lame la plus raide conférant une certaine élasticité et un moment d'inertie à l'ensemble.

Suivant une autre caractéristique, la lame la moins raide recouvre la lame la plus raide sur toute sa hauteur.

Suivant une autre caractéristique, la lame la plus raide est en métal et la lame la moins raide est en matériau synthétique.

Suivant une autre caractéristique, la lame la moins raide présente un fort coefficient de glissement du produit à appliquer.

Suivant une autre caractéristique, l'extrémité de la lame la moins raide dépasse l'extrémité de la lame la plus raide et est libre par rapport à celle-ci.

Suivant une autre caractéristique, la lame support comporte des encoches ou des fentes verticales.

D'autres avantages et caractéristiques de l'invention apparaîtront à la lecture de la description ci-après d'une forme de réalisation de l'invention donnée à titre d'exemple non limitatif et illustrée par les dessins joints dans lesquels :
- la figure 1 est une vue en coupe des racles selon l'art antérieur représentée au cours des phases successives d'une opération de raclage ;
- la figure 2 est une vue en coupe d'une racle selon l'invention ;
- les figures 3/4 représentent schématiquement le traitement de la crème lors du raclage ;
- la figure 5 représente une vue en coupe d'une opération de sérigraphie de l'art antérieur au moyen d'une racle métallique de l'art antérieur ;
- la figure 6 représente une vue en coupe d'une opération de sérigraphie avec une racle selon l'invention.

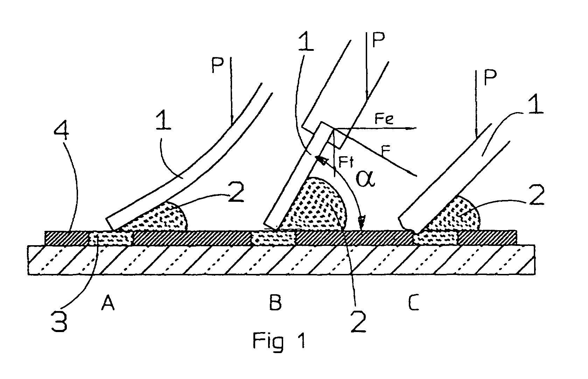

La figure 1 représente des racles 1 de l'art antérieur dans différentes phases de l'opération de sérigraphie pour transférer un produit 2 à travers les ouvertures 3 d'un pochoir 4.
La racle 1 est représentée en différentes positions A, B et C. En position A est représentée la déflexion de la racle sous l'effet de la pression P exercée sur la racle et de la réaction de la crème.
Dans ce cas de figure, une traînée de produit en fine pellicule reste à la surface du pochoir.
Cela génère en outre un mauvais contrôle de la quantité du produit transféré dans les ouvertures puisque de la crème est laissée de façon aléatoire sur les ouvertures du pochoir.

En position B, sont représentées la pression P exercée sur la racle ; F la force transmise par la racle à la crème à braser ; Fe la force nécessaire à l'entraînement de la crème et Ft la force de transfert nécessaire au passage de la crème à travers des ouvertures du pochoir.
La force de transfert Ft ne peut s'exercer que s'il y a mouvement de la racle. Pour un angle (alfa) donné entre la racle et le pochoir, la force de transfert est toujours la même quelle que soit la pression P exercée sur la racle.
Fe et Ft sont liées et directement fonction de l'angle (alfa) ;
si (alpha) augmente, Ft diminue,
si (alpha) égal 90°, Ft = 0.
Les produits, crème à braser, colle epoxy, colle conductrice, etc... devant être appliqués en couches épaisses, par exemple de 0,1 à 1 millimètre par sérigraphie à travers les ouvertures d'un pochoir doivent présenter une viscosité importante alliée à des caractéristiques de thixotropie.
La viscosité importante est nécessaire pour que les dépôts sérigraphiés ne s'affaissent pas et ne se déforment pas dans le temps.

La thixotropie est la caractéristique suivant laquelle la viscosité du produit est abaissée, le produit se fluidifiant lorsqu'il est soumis à des forces de cisaillement, le produit retrouvant sa viscosité originelle lorsque le cisaillement cesse.
Cette fluidification est nécessaire afin que le produit hautement visqueux puisse passer dans les ouvertures du pochoir qui peuvent être très petites, par exemple 0,1 millimètre.

Les crèmes à braser sont des produits très hétérogènes composés de particules métalliques et d'une partie organique dénommée liant ou flux.
La partie organique qui représente 50% du volume du produit et qui entoure chacune des sphères de l'alliage métallique remplit les fonctions de :
- désoxydation des surfaces à braser ;
- rhéologie de la crème à braser incluant la viscosité et la thixotropie ;
- protection des particules métalliques contre l'oxydation.

En raison de sa nature hétérogène, la crème à braser ne supporte pas les pressions importantes qui génèrent une ségrégation entre les particules métalliques et le flux ainsi que les frottements sur des surfaces agressives ou rugueuses.
Du fait de cette ségrégation, il peut y avoir une fuite de flux entre le pochoir et le substrat et un séchage de la crème sur le pochoir (figure 1A).

La figure 1C montre la déformation du profilé polyuréthanne dans les ouvertures du pochoir.

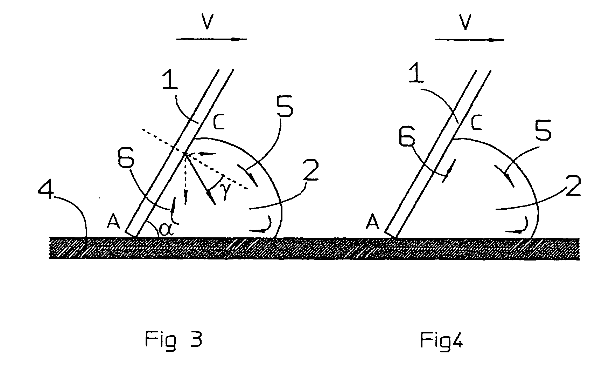

Le raclage des produits très visqueux tels que de la crème à braser est schématisé aux figures 3 et 4.
L'avance de la racle 1 combinée à l'adhésion du produit 2 sur le pochoir 4 génère un mouvement de rotation du produit (schématisé par les flèches 5) à condition que l'angle de raclage entre la racle et le pochoir soit suffisamment important.

Par contre, le glissement de la crème sur la face inclinée de la racle 1 (schématisé par les flèches 6) génère une réaction de la racle sur la crème qui s'oppose à l'écoulement de la crème qui s'effectue suivant l'angle (alpha) de la racle par rapport au pochoir et par rapport à la normale de l'arête AC constituée par la racle.
Il en résulte une surpression au niveau de l'arête A de la racle, surpression d'autant plus importante que la vitesse de raclage et la viscosité de la crème sont importantes.
Une diminution de l'angle de la racle par rapport au pochoir par exemple par une déflexion de la racle augmente également la pression près de l'arête A de la racle et l'adhésion de la crème à la racle en fonction de la rugosité de celle-ci et de sa tension superficielle augmente encore ce phénomène.

En fait, l'énergie totale au niveau de la racle issue de la pression P et de la vitesse V et de la valeur de l'angle (alpha) de la racle par rapport au pochoir 4 se traduit par une énergie cinétique qui brasse la crème en la faisant rouler et une mise en pression de la crème avec une énergie de frottement de la crème sur le pochoir et de la crème sur la racle et en énergie de frottement de la racle sur le pochoir.

Il est impératif pour obtenir un raclage satisfaisant que plusieurs paramètres soient respectés.
Il faut obtenir une mise en mouvement de la crème pour mettre en oeuvre et utiliser les capacités de thixotropie de la crème à braser.
Cette mise en mouvement par rotation ne peut être obtenue que si les conditions suivantes sont réunies :
- conserver un angle de raclage constitué par l'angle (alpha) de la racle par rapport au pochoir, constant entre la racle et le produit sans déformation localisée de la racle, ce qui est le cas avec les racles polyuréthannes;
- minimiser la pression sur la racle afin de ne pas modifier l'angle de raclage constitué par l'angle (alpha) de la racle par rapport au pochoir ;
- favoriser le glissement du produit sur la racle, ce qui revient à minimiser l'angle de frottement (gamma).
Ce résultat est obtenu lorsque la rugosité et la tension superficielle du matériau de la racle en contact avec la crème sont le plus faible possible.
- Eviter de désorganiser la structure de la crème à braser par ségrégation ou altération de la partie organique par frottement sur des surfaces agressives, ce qui provoque une mise à l'air des particules métalliques constituées par les billes d'alliage et leur oxydation.

Il faut également pour une bonne maîtrise des volumes et une bonne définition des dépôts, racler proprement la surface du pochoir.
Pour cela, il est nécessaire :
- de maîtriser la force d'appui de la racle tout au long de l'arête de raclage ;
- absorber les ondulations courtes et longues.

Dans la sérigraphie des cartes électroniques, il se présente fréquemment des variations de hauteur sur le substrat.
Les variations de hauteur sont habituellement liées à la présence des pistes de vernis-épargne ou encore à la nature du revêtement des plages d'accueils et sont généralement de l'ordre de 50 microns.
Lorsque ces variations de hauteur sont plus importantes, par exemple, lorsqu'elles sont dues à la présence de vernis-épargne pelable ou aux bords des cartes, on obtient des ondulations courtes sur le pochoir, c'est à dire dont le rayon de courbure est inférieur à 10 millimètres.
Lorsque ces variations de hauteur sont plus progressives, c'est le cas par exemple de cartes reposant sur un mauvais support ou de cartes déformées, on obtient des ondulations longues sur le pochoir, c'est à dire des ondulations dont le rayon est supérieur à 10 millimètres.

Avec les racles en métal ou en polyuréthanne, ces ondulations génèrent des variations importantes de force le long de l'arête de la racle.
Les ondulations courtes conduisent dans le cas des racles métalliques à des décollements entre la racle et le pochoir sur parfois plusieurs dizaines de millimètres autour du point haut et à des pressions très élevées au niveau du point haut, ce qui peut générer une déformation permanente du pochoir.

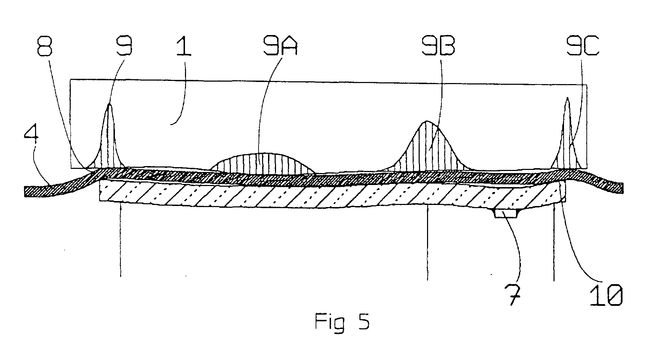

Le raclage dans ces conditions quelle que soit la pression exercée sur la racle ne pourra pas être satisfaisant.
Dans le cas de racles polyuréthannes, ces variations de hauteur se traduisent par des différences importantes de la force appliquée le long de la racle et également par des déformations de son arête, ce qui change le profil de la racle.
En figure 5, ce problème est représenté.

Une racle 1 métallique est appliquée sur un pochoir 4 posé sur une carte de circuit électronique dont un composant 7 est représenté.
La crème à braser doit être déposée au dos du circuit, la face avant portant le composant 7.
Le support de la carte ou substrat est représenté de façon schématique pour simplifier le dessin.

En 8 est représentée une déformation permanente du pochoir sur le bord du substrat. Cette déformation génère une pression accrue 9 de la racle sur une faible longueur.

En 10 est représentée une ondulation courte du pochoir.
La racle ne peut se conformer aux variations de hauteur et l'on a représenté sur le dessin le décollement de la racle par rapport au pochoir.
Ce décollement génère des traînées de crème derrière la racle, le pochoir ne subissant pas la pression de la racle n'est pas plaqué sur le substrat ou carte avec possibilité de migration de crème entre le pochoir et la carte.
Les références 9/9A/9B et 9C schématisent la répartition de la pression d'appui de la racle sur le pochoir.

Enfin, un autre paramètre doit être réuni aux précédents pour que le raclage soit satisfaisant.
Il est nécessaire que la racle au niveau de son arête (figure 1c) ne se déforme pas dans les ouvertures du pochoir.
Dans le cas notamment de racles polyuréthannes et en particulier lorsque les ouvertures du pochoir sont importantes, la racle en se déformant et en rentrant dans l'ouverture réentraîne une partie du produit présent dans l'ouverture.
Il en résulte que la quantité de produit déposé n'est pas maîtrisée et que les dépôts n'ont pas une forme régulière.

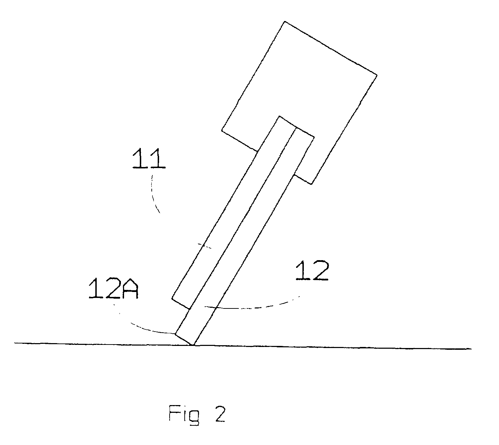

La racle selon l'invention d'application d'un produit présentant un degré de viscosité important et des caractéristiques de thixotropie sur un substrat pouvant présenter des variations de hauteur, se distingue en ce qu'elle est constituée comme représentée en figure 2 par la superposition l'une contre l'autre dans le plan transversal selon la hauteur de la racle et dans le plan longitudinal de deux lames 11/12 de matériaux de raideur différente dont une 11 est plus rigide et l'autre moins rigide 12 et dont l'une la moins rigide dépasse l'arête inférieure de la lame la plus rigide.

La lame 11 et la lame 12 sont superposées l'une sur l'autre avec dépassement de la lame 12.
Elles peuvent être fixées l'une à l'autre par collage au moyen d'une colle adaptée.

La première lame 11 dite de support, la plus raide, confère une certaine élasticité et un moment d'inertie à l 'ensemble suivant l'axe longitudinal et transversal. A titre purement indicatif, la rigidité par unité de hauteur de ladite lame est supérieure ou égale à 140 N.mm.
C'est elle qui permet d'absorber les ondulations de grande longueur.
Elle présente en outre de par sa raideur choisie une résistance à la déflexion en particulier lorsque la sérigraphie est effectuée à vitesse importante.
Cette lame ou racle support 11 raide du fait du dépassement en 12A de la racle moins raide 12, qui est plus haute, n'entre pas en contact avec le pochoir sur lequel elle n'a pas d'action.

La deuxième lame 12 moins raide, dite lame ou racle de transfert, est en contact par 12A avec le pochoir.
Elle présente une dureté adéquate pour d'une part, ne pas user le pochoir et d'autre part, ne pas se déformer dans les ouvertures du dit pochoir, (ceci grâce à un module d'élasticité supérieur ou égal à 3900 N/mm2 et une résistance à la rupture R supérieure ou égale à 150 N/mm2), ce qui outre son usure rapide provoquerait un réentraînement du produit.
Des essais ont montré qu'une rigidité par unité de hauteur de 40 N.mm environ présente un bon compromis.
La valeur du dépassement 12A par rapport à la lame 11 et sa flexibilité sont déterminantes pour absorber les ondulations de petite longueur tout en entraînant la crème.

Plusieurs combinaisons de matériaux utilisés pour la lame 11 et pour la lame 12 sont possibles.
Les essais effectués ont été satisfaisants avec une lame support 11 en acier inoxydable (par exemple de qualité Z11 CN 18.08) d'épaisseur de 0,2 ou 0,3 millimètre et avec une lame de transfert 12 en un matériau synthétique par exemple du polyester dont l'épaisseur peut être comprise entre 0,35 et 0,5 millimètre avec une capacité de déplacement de la partie 12A de la racle transfert en dépassement de la racle support de 1 à 2 millimètres.

Suivant une autre caractéristique de l'invention, afin de diminuer le moment d'inertie suivant l'axe longitudinal tout en gardant une valeur importante suivant l'axe transversal (la hauteur), il est possible de pratiquer des encoches ou des fentes verticales régulièrement espacées et sur une hauteur déterminée et identique pour chaque encoche ou fente sur la lame support 11, ce qui permet une meilleure conformation de la racle composite obtenue aux variations de hauteur du pochoir et du substrat.

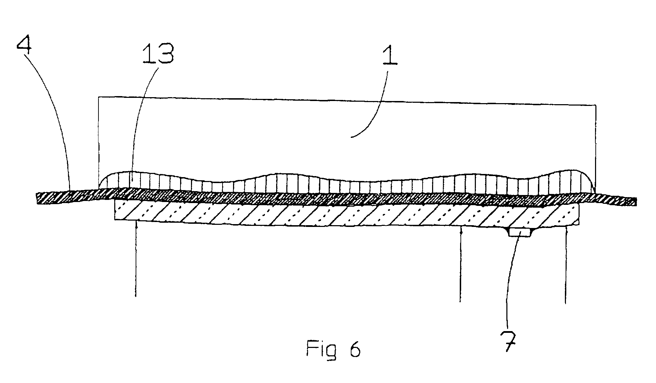

La figure 6 représente schématiquement en coupe longitudinale une racle 1 composite selon l'invention sur un pochoir 4 lui-même appliqué sur un substrat.
Les flèches 13 représentent la répartition de la pression d'appui de la racle sur le pochoir, répartition qui est homogène.
Cela permet d'obtenir un contact étroit entre le substrat ,le pochoir et la racle et de réduire les déformations du pochoir, ce qui réduit les risques de détérioration des composants (schématisé ici par 7).

La racle de transfert 12 en matériau synthétique recouvre la racle support 11 sur toute sa hauteur.
Son énergie de surface est moindre que celle de la racle support et elle offre un coefficient de glissement de la crème important, ce qui facilite la rotation de la crème dont l'utilité pour la fluidification a été énoncée précédemment.

La racle selon l'invention permet d'obtenir un ressort en sorte que la face d'appui sur le pochoir est constante quelles que soient les variations de hauteur par exemple + 0,5 millimètre et en sorte que soient acceptés des rayons de courbure extrêmement faibles, par exemple de l'ordre de 1 millimètre, sans changer le profil de l'arête de raclage par utilisation à ce niveau de la flexibilité de la partie en dépassement de la lame la moins raide.

La partie la moins raide de la racle qui est en polyester permet d'absorber les variations brutales de hauteur tout en gardant (figure 6) un contact linéaire entre la racle et le pochoir.
L'angle (alpha) de la racle avec le pochoir (figure 1) dans l'application de la racle selon l'invention ne se trouve modifié qu'à l'endroit exact de la surépaisseur et est inchangé ailleurs.

## Revendications

1. Racle d'application d'un produit (2) présentant un degré de viscosité important et des caractéristiques de thixotropie sur un substrat qui peut présenter des variations de hauteur, à travers un pochoir (4) appliqué au dit substrat **caractérisée en ce qu'**elle est constituée par superposition l'une contre l'autre d'au moins deux lames flexibles (11, 12) de raideur différente et de hauteur différente dont une, la moins raide (12) dépasse le bord inférieur de la plus raide (11), ladite lame la moins raide (12) étant au contact du produit à appliquer et la lame la plus raide (11) étant du côté opposé, ladite lame la plus raide (11) conférant une certaine élasticité et un moment d'inertie à l'ensemble.

2. Racle selon la revendication 1 **caractérisée en ce que** la lame la moins raide (12) recouvre la lame la plus raide (11) sur toute sa hauteur.

3. Racle selon la revendication 1 ou la revendication 2 **caractérisée en ce que** la lame la plus raide (11) est en métal et que la lame la moins raide (12) est en matériau synthétique.

4. Racle selon l'une des revendications précédentes **caractérisée en ce que** la lame la moins raide (12) présente un fort coefficient de glissement du produit à appliquer.

5. Racle selon l'une des revendications précédentes **caractérisée en ce que** l'extrémité de la lame la moins raide (12) dépasse l'extrémité de la lame la plus raide (11) et est libre par rapport à celle-ci.

6. Racle selon l'une des revendications précédentes **caractérisée en ce que** la lame support (11) comporte des encoches ou des fentes verticales.

## Patentansprüche

1. Rakel zum Auftragen eines Produkts (2) mit sehr hoher Viskosität und thixotropen Eigenschaften auf ein Substrat von gegebenenfalls variabler Höhe durch eine auf das Substrat gelegte Schablone (4), **dadurch gekennzeichnet, daß** sie aus mindestens zwei aufeinandergelegten biegsamen Blättern (11, 12) von verschiedener Steifheit und verschiedener Höhe besteht, von denen das Blatt mit der geringsten Steifheit (12) die Unterkante des Blatts mit der größten Steifheit (11) überragt, wobei das Blatt mit der geringsten Steifheit (12) im Kontakt mit dem aufzubringenden Produkt ist und das Blatt mit der größten Steifheit (11) sich auf der entgegengesetzten Seite befindet, und das Blatt mit der größten Steifheit (11) der Gesamtanordnung eine gewisse Elastizität und einen Trägheitsmoment verleit.

2. Rakel nach Anspruch 1, **dadurch gekennzeichnet, daß** das Blatt mit der geringsten Steifheit (12) das Blatt mit der größten Steifheit (11) über dessen ganze Höhe bedeckt.

3. Rakel nach Anspruch 1 oder 2, **dadurch gekennzeichnet, daß** das Blatt mit der größten Steifheit (11) aus Metall und das Blatt mit der geringsten Steifheit (12) aus Kunststoff ist.

4. Rakel nach einem der vorangehenden Ansprüche, **dadurch gekennzeichnet, daß** das Blatt mit der geringsten Steifheit (12) einen hohen Gleitkoeffizienten des aufzubringenden Produkts aufweist.

5. Rakel nach einem der vorangehenden Ansprüche, **dadurch gekennzeichnet, daß** das Ende des Blatts mit der geringsten Steifheit (12) das Ende des Blatts mit der größten Steifheit (11) überragt und diesem gegenüber frei ist.

6. Rakel nach einem der vorangehenden Ansprüche, **dadurch gekennzeichnet, daß** das stützende Blatt (11) vertikale Ausnehmungen oder Schlitze aufweist.

## Claims

1. A doctor blade for applying a product (2) having a considerable degree of viscosity and thixotropy characteristics on to a substrate which may have variations in height, through a stencil (4) applied to said substrate, **characterised in that** it is formed by superimposing one against the other at least two flexible blades (11,12) of different stiffness and different height, one of which, the one which is least stiff, extends beyond the lower edge of the stiffest one (11), said least stiff blade (12) being in contact with the product to be applied and the stiffest blade (11) being on the opposite side, said stiffest blade (11) imparting a degree of elasticity and a moment of inertia to the assembly.

2. A doctor blade according to claim 1, **characterised in that** the least stiff blade (12) overlaps the stiffest blade (11) over its entire height.

3. A doctor blade according to claim 1 or claim 2, **characterised in that** the stiffest blade (11) is made of metal and **in that** the least stiff blade (12) is made of synthetic material.

4. A doctor blade according to any one of the preceding claims, **characterised in that** the least stiff blade (12) has a high coefficient of slip for the product to be applied.

5. A doctor blade according to any one of the preceding claims, **characterised in that** the end of the least stiff blade (12) extends beyond the end of the stiffest blade (11) and is free with respect thereto.

6. A doctor blade according to any one of the preceding claims, **characterised in that** the support blade (11) has vertical slots or notches.
